# EUROPEAN PATENT SPECIFICATION

(11) **EP 4 202 987 B1**
(45) Date of publication and mention of the grant of the patent: **02.12.2026**
(21) Application number: 22205269.8
(22) Date of filing: 03.11.2022
(51) Int. Cl.: H10W 20/00

(54) **INTERCONNECT LINE STRUCTURES WITH METAL CHALCOGENIDE CAP MATERIALS**
VERBINDUNGSLEITUNGSSTRUKTUREN MIT METALLCHALKOGENIDKAPPENMATERIALIEN
STRUCTURES DE LIGNES D'INTERCONNEXION AVEC DES MATÉRIAUX DE CAPUCHON EN CHALCOGÉNURE MÉTALLIQUE

(30) Priority: 22.12.2021 US 202117560089
(43) Date of publication of application: 28.06.2023
(73) Proprietor: Intel Corporation, Santa Clara, CA 95054 (US)
(72) Inventor: Naylor, Carl H., Portland, 97229 (US); Jezewski, Christopher, Portland, 97229 (US)
(74) Representative: Goddar, Heinz J.

(56) References cited:
- US-A1- 2005 127 479
- US-A1- 2018 033 727
- US-A1- 2021 111 129
- US-B1- 8 021 486

## Description

### BACKGROUND

Demand for higher performance integrated circuits (ICs) in electronic device applications has motivated increasingly dense transistor architectures. Interconnect parasitics become a greater challenge as the density of interconnect metallization structures keeps pace with transistor density. For example, the resistance-capacitance (RC) delay product associated with interconnects of an IC increases with the density of the interconnects.

Prior art document US2018/0033727 A1 discloses metal wiring patterns in an interlayer dielectric layer.

Document US2005/0127479 A1 discloses interconnect structures and methods for their fabrication.

Document US2021/0111129 A1 discloses an interconnect fabricated with flowable copper.

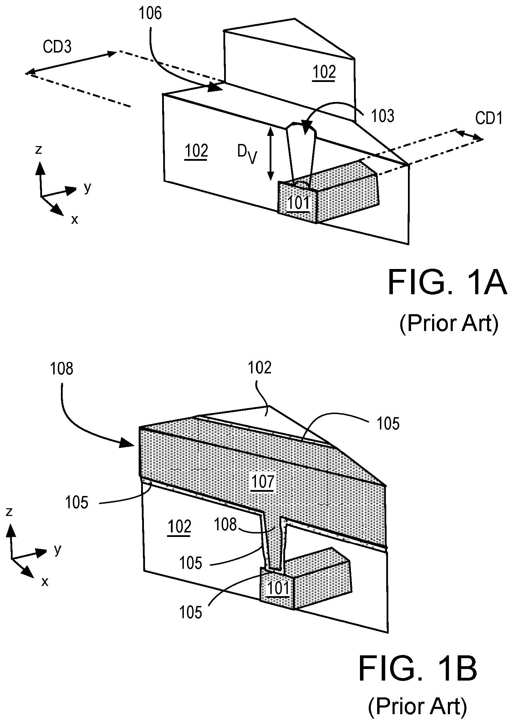

FIG. 1A illustrates a conventional interconnect structure that includes a metal line 101 within a first interconnect level. A transverse width of metal line 101 has some lateral critical dimension CD1. A dielectric material 102 is over metal line 101, and a "via" 103 is subtractively patterned through dielectric material 102 in the z-dimension to expose a portion of metal line 101.

As further illustrated in FIG. 1B, via 103 and a trench 106 is filled with one or more metals to form an interconnect line 108 that extends in the x-y dimension to intersect conductive material in via 103 so that two interconnect levels are electrically connected. In this example, liner material 105 is on a bottom and a sidewall of trench 106 and/or interconnect line 108. Liner material 105 may include a barrier material to prevent diffusion/migration of a bulk material 107 out of the interconnect structure, as any loss of bulk material 107 can be catastrophic to an integrated circuit. Liner material may also include an adhesion material instead of a barrier material, or in addition to a barrier material. An adhesion material is to improve adhesion of a bulk material 107 that would otherwise suffer poor adhesion with an underlying material, such as a barrier material, and/or dielectric material 102.

Although not illustrated in FIG. 1B, a dielectric material, such as SiONₓ, is often deposited over interconnect line 108 to complete encapsulation of bulk material 107 and thereby minimize diffusion/migration. Interconnect line architectures, and techniques for forming such line architectures, that can reduce the electrical resistance of interconnect line 108 are commercially advantageous at least for their associated reduction in RC delay.

### BRIEF DESCRIPTION OF THE DRAWINGS

According to the present invention, an integrated circuit, IC, interconnect structure is disclosed as recited in claim 1, and a method of fabricating an integrated circuit, IC, interconnect structure is disclosed as recited in claim 10. Further embodiments are recited in the dependent claims.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A and 1B illustrate isometric cross-sectional views of an IC interconnect structure, in accordance with convention;
FIG. 2 is a flow chart of methods of fabricating one level of an integrated circuit interconnect structure having a low resistance line comprising a metal chalcogenide cap, in accordance with some embodiments;
FIG. 3A, 4A, 5A, and 6A illustrate a plan view of a portion of an IC interconnect structure evolving as the methods illustrated in FIG. 2 are practiced, in accordance with some dual-damascene embodiments;
FIG. 3B, 4B, 5B and 6B illustrate a cross-sectional view of a portion of an IC interconnect structure evolving as the methods illustrated in FIG. 2 are practiced, in accordance with some dual-damascene embodiments;
FIG. 7A, 8A, 9A, and 10A illustrate a plan view of a portion of an IC interconnect structure evolving as the methods illustrated in FIG. 2 are practiced, in accordance with some single-damascene embodiments;
FIG. 7B, 8B, 9B, and 10B illustrate a cross-sectional view of a portion of an IC interconnect structure evolving as the methods illustrated in FIG. 2 are practiced, in accordance with some single-damascene embodiments;
FIG. 11 illustrates a mobile computing platform and a data server machine employing an IC including an interconnect structure with a low resistance line comprising a metal chalcogenide cap, in accordance with some embodiments; and
FIG. 12 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, it should be understood that this is done for illustrative purposes only.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

The term "adjacent" here generally refers to a position of a thing being next to (e.g., immediately next to or close to with one or more things between them) or adjoining another thing (e.g., abutting it).

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

The term "signal" may refer to at least one current signal, voltage signal, magnetic signal, or data/clock signal.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As used throughout this description, and in the claims, a list of items joined by the term "at least one of" or "one or more of" can mean any combination of the listed terms.

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

As described below, one or more chalcogenation techniques may be integrated into a damascene interconnect process to cap an interconnect line in a manner that can reduce electrical resistance of the interconnect line. The inventors have found chalcogenation of a top portion of a bulk material in the interconnect line can lower scattering resistance of the line relative to alternatives where the bulk material is capped with an alternative material, such as an amorphous dielectric or a fine grained metallic or graphitic material. As described further below, chalcogenation of a top portion of a bulk material may advantageously crystallize the top line portion into a metal chalcogenide cap having exceptionally large crystal structure offering a significant reduction in integrated circuit interconnect line resistance. As also described below, chalcogenation of a top portion of a bulk like metal in accordance with embodiments herein may incur a negligible interconnect line volume penalty because a top portion of the bulk material is converted to a metal chalcogenide cap as opposed to a discrete cap material being layered upon the bulk line metal.

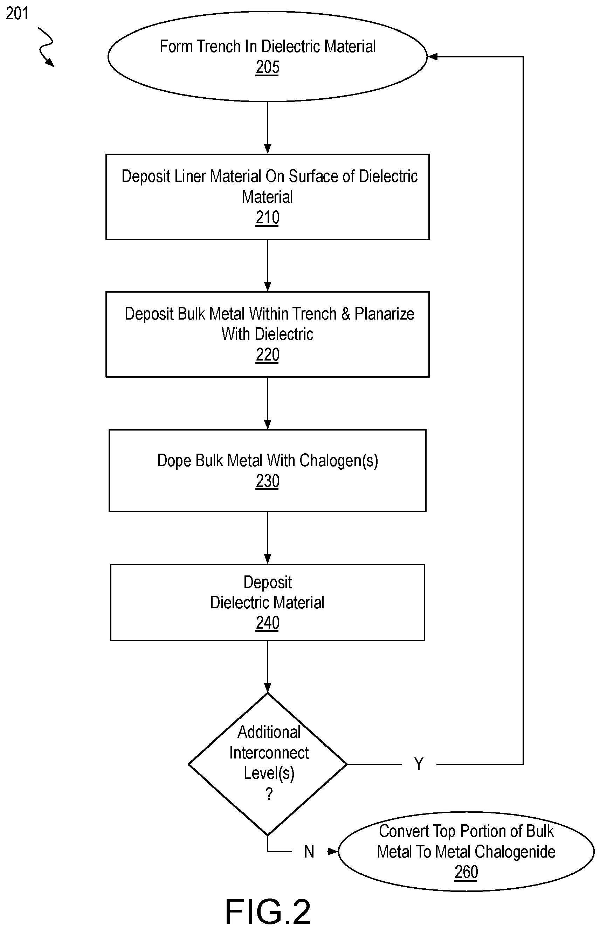

FIG. 2 is a flow chart of methods 201 for fabricating one level of an integrated circuit interconnect structure having a low resistance line, in accordance with some embodiments. Methods 201 may be practiced on a workpiece, such as a large format (e.g., 300-450mm) semiconductor wafer. The wafer may include a Group IV semiconductor material layer (e.g., Si, Ge, SiGe, GeSn, etc.), a Group III-V semiconductor material layer, or a Group II-VI semiconductor material layer, for example. The workpiece may include one or more underlying device layers including a semiconductor material layer, and may also have one or more interconnect levels interconnecting devices (e.g., transistors) of the devices layers.

Methods 201 begin at operation 205 where at least a trench is subtractively patterned into one or more dielectric materials of an IC interconnect structure. The trench may be any "dual-damascene" type structure that further includes a via opening in the dielectric materials, or any "single-damascene" type structure that exposes an underlying conductive via previously fabricated in the workpiece. The trench may be patterned into any dielectric material(s) suitable as an IC interlayer dielectric material (ILD). In some exemplary embodiments, the trench is formed in a low-k dielectric material, for example having a relative permittivity less than about 3.4. The trench may also be formed in a conventional dielectric material having a somewhat higher relative permittivity in the range of 3.5-9. The trench may also be formed in a high-k dielectric material having an even higher relative permittivity, for example exceeding 9.5. In some specific examples, the trench is formed in one of SiOC(H), hydrogen silsesquioxane, methyl silsesquioxane, polyimide, polynorbornene, benzocyclobutene SiNₓ, SiO₂, SiOₓN_{y}, HfO₂, ZrO, or Al₂O₃.

In dual-damascene embodiments, both a trench and a via opening are patterned into the dielectric material at operation 205. In single-damascene embodiments, only a trench is patterned at operation 205. The trench patterned at operation 205 exposes some underlying interconnect metallization feature, such as a conductive via or a conductive interconnect line. For example, in a dual-damascene interconnect fabrication process, a via, but not the trench, exposes some region of an underlying metallization line or via of a lower-level interconnect structure. In a single-damascene interconnect fabrication process, the trench formed at operation 205, exposes some region of an underlying metal-filled conductive via of a lower-level interconnect structure.

Methods 201 continue at operation 210, wherein one or more liner material layers are deposited upon dielectric surfaces of the trench. Any deposition process known to be suitable for depositing a particular liner material into a trench may be practiced at operation 210 as embodiments herein are not limited in this respect. The liner material layer(s) may be deposited non-selectively, in which case the liner material layer(s) also accumulates on surfaces of any metallization exposed within the trench. The liner material layer(s) may also be deposited selectively, for example on the dielectric surfaces in preference over "non-growth" surfaces of a metallization exposed within the trench. The liner material layer(s) may be deposited to any thickness functional as a barrier layer and/or adhesion layer.

Methods 201 continue at operation 220 where one or more bulk line metals are deposited in contact with an uppermost one of the liner materials layer(s). Any deposition process known to be suitable for depositing a particular bulk material into a trench and/or via opening may be practiced at operation 220 as embodiments herein are not limited in this respect. In some examples, an electrolytic plating process is practiced at operation 220 to deposit a bulk material. In further embodiments, multiple deposition processes may be practiced at operation 220. For example, an electrolytic plating process may be preceded by physical vapor deposition (PVD) of a seed layer. Deposition of the bulk materials may also comprise PVD, chemical vapor deposition (CVD), atomic layer deposition (ALD), or electroless plating. For example, a wetting material layer may be deposited by PVD, CVD, ALD or electroless plating prior to an electrolytic plating of a bulk material comprising predominantly copper (Cu). Although the deposition of Cu is one exemplary embodiment, other metals may be deposited at operation 220. For example, one or more of Mo, W, Ru, Re, Co, Ir, Rh, Pt, Pd or Al may be deposited in the alternative to Cu, or in conjunction with Cu.

Operation 220 is completed with a planarization of at least the bulk material and the liner material (layers) to expose a top surface of the dielectric material surrounding the trench. The planarization process may remove any bulk material and liner material from the dielectric material in regions beyond a perimeter of an interconnect line structure. Any planarization (e.g., CMP) process may be practiced to complete the metallization of an interconnect feature.

Methods 201 continue at operation 230 where a top portion of the bulk material following planarization is a metal *M* is doped with a chalcogen C (i.e., a chalcogen-doped metal *M:C*). In some examples, operation 230 comprises heating the workpiece to over 100°C (e.g., 125°C, 150°C, 200°C, or 250°C) while exposing the top surface of the bulk line metal to a chalcogenide precursor gas. Within the bulk material, the chalcogen dopant concentration may therefore be highest proximal to the surface and decline with distance from the surface.

As used herein, chalcogens include sulfur, selenium or tellurium (oxygen is excluded). The precursor gas may have various compositions, with some examples including H₂S, H₂Se, H₂Te. These gaseous precursor compounds may readily degrade to their respective elements at the elevated temperature of the heated substrate. These exemplary precursor gases can also act as strong reducing agents, so they may be combined or replaced with weaker reducing agents/stronger oxidizing agents. Gases including oxygen, for example, temper the reducing strength more than those that lack oxygen. In some embodiments, SO₂ or SeO₂ may be introduced in combination with, or to the exclusion of, H₂S or H₂Se, for example. Other gases, such as, NH₃, N₂, Ar, N₂O, or SₓO_{y}, SeₓO_{y}, TeₓO_{y} with x or y being 1, 2 (e.g., SO₂, SeO₂) or 3, or SF_{z}, Se_{z} or Te_{z} with z either 4 or 6 (e.g., SF₆, TeF₆) may also be introduced in combination with one or more of H₂S and, H₂Se and or H₂Te. For the duration of operation 230 the chalcogen(s) diffuse into the bulk material, doping the bulk material to some peak concentration within a certain distance from the top surface of the bulk material.

Methods 201 continue at operation 240 where one or more dielectric materials are deposited over the chalcogen doped interconnect line. In some embodiments, the dielectric material deposited at operation 240 is suitable as a diffusion barrier. For example, the dielectric material deposited at operation 240 may comprise silicon and nitrogen (e.g., SiNₓ or SiOₓN_{y}). However, the dielectric material deposited at operation 240 may also be any material known to be suitable as an interlayer dielectric (ILD) material in reliance of the chalcogen dopant ultimately forming a cap material having an adequate diffusion barrier in addition to reducing scattering resistance of the bulk material.

Methods 201 may be repeated for any number of successive interconnect levels. If no more interconnect levels are to be fabricated, methods 201 complete with a transient thermal process at operation 260 that converts a top portion of the bulk line metal into a metal chalcogenide (e.g., *MCₓ).* Operation 260 may be a furnace anneal, a flash anneal, or laser anneal, for example. A furnace anneal (or other anneal) may be performed in a forming gas or other ambient at a predetermined temperature and duration sufficient to react the bulk material within regions having a sufficiently high concentration of chalcogen doping into the metal chalcogenide. Where chalcogen doping is insufficient to form the metal chalcogenide, the chalcogen dopant may migrate toward the metal chalcogenide, feeding the conversion, or may migrate toward interfaces of the bulk material and the liner material and/or to surrounding dielectric material interface(s). In some embodiments, the anneal is performed at a temperature compatible with backend processing (e.g., <400 °C). In some embodiments, the anneal performed at operation 260 is at a higher temperature than the temperature at which the chalcogen dopant is introduced into the metallization at operation 230. For example, where a chalcogen dopant is introduced into a bulk material of predominantly Cu at a temperature less than 250°C, the anneal performed at operation 260 is at a temperature of 250-350 °C.

In some examples where interconnect features are predominantly Cu, a cap comprising a Cu chalcogenide is formed within the top portion of the interconnect line. Exemplary Cu chalcogenides include CuSₓ, CuSeₓ, CuSeₓS_{y}, CuTeₓ, or CuSeₓTe_{y}. Although the Cu chalcogenide may advantageously be a dichalcogenide (e.g., Cu₂S such that x is 0.5), it may not be a dichalcogenide and x may vary. In other embodiments where an interconnect line comprises an alternative bulk material, (e.g., predominantly Mo, W, Ru, Re, Co, Ir, Rh, Pt, Pd, Al, etc.), the corresponding alternative metal chalcogenide (e.g., MoSₓ, WSₓ, RuSₓ, ReSₓ, CoSₓ, IrSₓ, RhSₓ, PtSₓ, PdSₓ, AlSₓ, etc.) may be similarly formed within a top portion of the bulk and may also be a metal dichalcogenide.

The thermal processing may therefore form a metal chalcogenide cap of different crystallinity than the bulk material. Hence, the microstructure of the metal chalcogenide cap will be distinct from that of the bulk material. The metal chalcogenide cap may be considered a 2D material as a result of its crystalline microstructure (i.e., long range atomic ordering) within a 2D plane of each monolayer that is substantially parallel to the plane of the IC interconnect line.

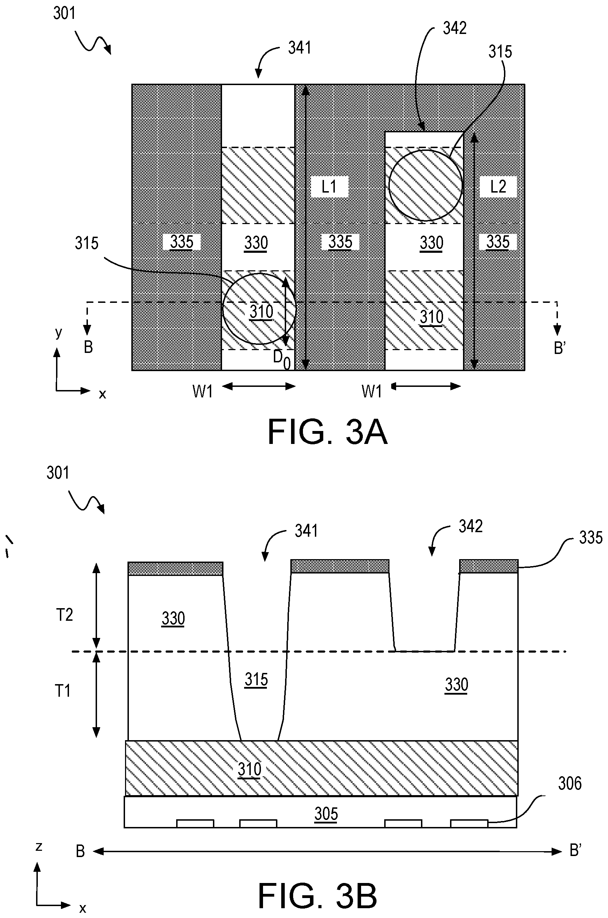

FIG. 3A, 4A, 5A, and 6A illustrate a plan view of a portion of an IC interconnect structure portion 301 evolving as the methods 201 are practiced, in accordance with some dual-damascene embodiments. FIG. 3B, 4B, 5B and 6B further illustrate a cross-sectional view of a portion of IC interconnect structure portion 301 evolving, in accordance with some dual-damascene embodiments.

Referring first to FIG. 3A and FIG. 3B, interconnect structure portion 301 includes a via opening 315 through a thickness T1 of one or more dielectric materials 330. Thickness T1 may vary with implementation, but in some exemplary embodiments is 10nm-50nm. An underlying metallization feature (e.g., a line) 310 is exposed at a bottom of via opening 315. Metallization feature 310 is in a lower interconnect level below dielectric materials 330. Metallization feature 310 may have any composition, with some examples including copper, tungsten, titanium, cobalt, ruthenium, manganese, or aluminum. In FIG. 3A, portions of metallization feature 310 outlined in dashed line are below the surface.

Interconnect structure portion 301 further includes trench 341 over via opening 315, within a thickness T2 of dielectric materials 330. Thickness T2 may vary with implementation, but in some exemplary embodiments is 10-50 nm, or more. Another trench 342 laterally spaced apart from trench 341 is further illustrated, and the cross-section of trench 342 shown in FIG. 3B is representative of a cross-section of trench 341 out of the plane of the FIG. 3B where there is no via opening 315. As shown in FIG. 3A, trench 341 has a longitudinal length L₁ and a transverse width W₁. In exemplary embodiments, longitudinal length L₁ is significantly (e.g., 3x) larger than transverse width W₁. Although not illustrated, trench 341 has ends somewhere beyond the perimeter of interconnect structure portion 301. Trench 342 is substantially parallel to trench 341, but with a shorter longitudinal length L₂ to further illustrate a trench end. An etch stop material layer 335 is over dielectric materials 330, surrounding trenches 341, 342. Via opening 315 has a maximum lateral diameter D₀, which may vary with implementation, but is generally significantly smaller than the length of a trench (e.g., diameter D₀ is significantly smaller than longitudinal lengths L₁ and L₂).

Any single-step or multi-step anisotropic reactive ion etch (RIE) process (e.g., based on a CₓF_{y} plasma chemistry) may have been practiced to form trenches 341, 342 and via opening 315, as embodiments are not limited in this respect. Trenches 341, 342 and via opening 315 are depicted with a tapered sidewall and positive slope such that a top width of via opening 315 is slightly larger than the bottom width. While such tapered slope is representative of subtractively patterned dielectrics, other profiles are possible as a function of the dielectric etch process.

Dielectric materials 330 may include any dielectric material suitable for electrical isolation of integrated circuitry. Dielectric materials 330, may, for example, be low-k dielectric materials (e.g., SiOC) having a relative permittivity below 3.4. In other examples, dielectric materials 330 may be any of SiO, SiON, hydrogen silsesquioxane, methyl silsesquioxane, polyimide, polynorbornenes, benzocyclobutene, or the like. Dielectric materials 330 may be deposited as a flowable oxide, for example, and have a substantially planar top surface. Etch stop material layer 335 may also be a dielectric material, but advantageously has a different composition than dielectric materials 330. Etch stop material layer 335 may have a somewhat higher relative permittivity than dielectric materials 330, for example. Etch stop material layer 335 may have any composition such as, but not limited to, SiN, SiO, SiON, HfO₂, ZrO, Al₂O₃, for example. Etch stop material layer 335 may have any thickness, but in some advantageous embodiments has a thickness less than 10nm, and advantageously no more than 5nm (e.g., 2-3nm, etc.). In accordance with some further embodiments, dielectric materials 330 may further include an intervening trench etch stop material layer represented in FIG. 3B as a dashed line between dielectric material thicknesses T1 and T2.

As further shown in FIG. 3B, interconnect structure portion 301 is over a portion of an underlying substrate that includes a device layer 305. Within device layer 305 are a plurality of devices 306. In exemplary embodiments, devices 306 are metal-oxide-semiconductor field effect transistor (MOSFET) structures. However, devices 306 may also be other transistor types, such as, but not limited to other FET architectures, or bipolar junction transistors. Devices 306 may also be other devices that include one or more semiconductor junctions (e.g., diodes, etc.).

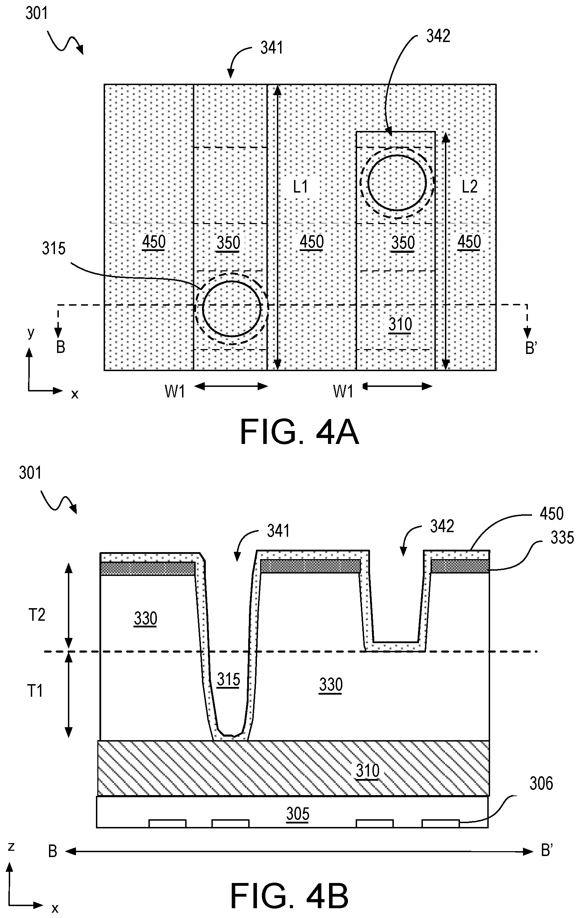

In the example further illustrated in FIG. 4A and FIG. 4B, a liner material 450 has been deposited over interconnect structure portion 301. In some embodiments, liner material 450 has a composition known to be suitable as a diffusion barrier. In some diffusion barrier examples, liner material 450 comprises a metal, such as, but not limited to, Ta, Mo, W, or Al. In some other embodiments, liner material 450 has a composition known to be suitable as an adhesion layer. In some adhesion layer examples, liner material 450 comprises a metal, such as, but not limited to, Ti, W or Pt. Liner material 450 may also comprise a metal compound that further includes at least one of Si, N, C, B, P or O. In some specific embodiments, liner material 450 further comprises nitrogen (e.g., TaN, WN, TiN, etc.). Liner material 450 may be substantially amorphous or may be polycrystalline.

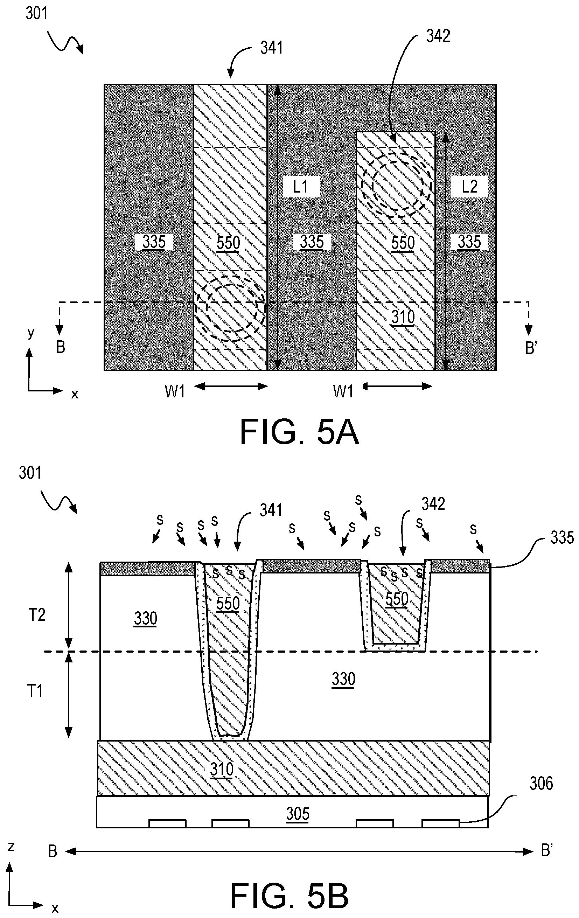

In the example further illustrated in FIG. 5A and FIG. 5B, one or more layers of interconnect bulk material 550 have been deposited into trenches 341, 342 and via opening 315. Bulk material 550 substantially backfills via opening 315 as well as trenches 341 and 342. In some exemplary embodiments, bulk material 550 comprises predominantly copper. In other embodiments, bulk material 550 comprises predominantly one of Mo, W, Ru, Re, Co, Ir, Rh, Pt, Pd, Al. As shown in FIG. 5B, bulk material 550, as well as liner material 450, is substantially planar with a top surface of the workpiece (e.g., etch stop material layer 335).

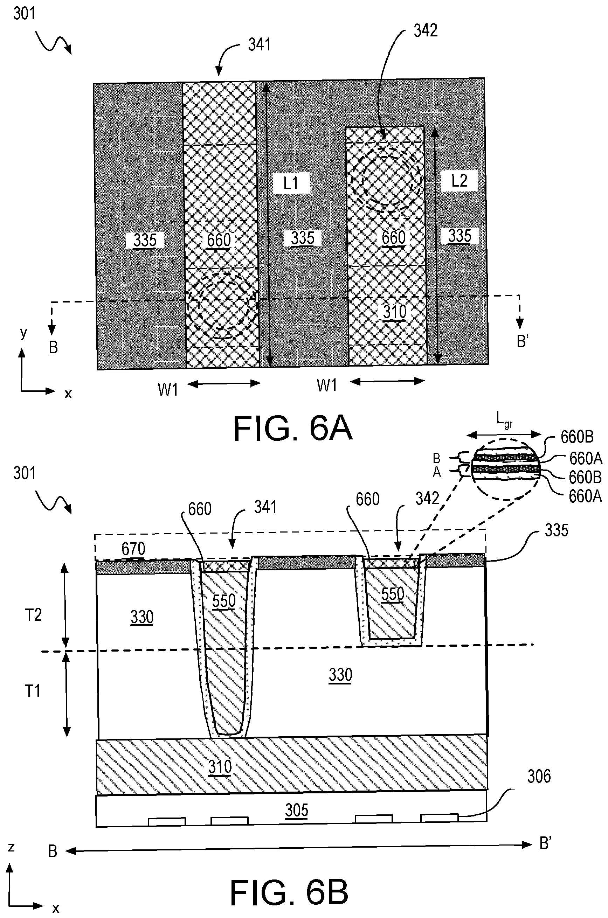

FIG. 5B further illustrates chalcogen doping of interconnect structure portion 301, for example according to the techniques described above in the context of operation 230 (FIG. 2). Although sulfur ("S") is shown, Se may also be introduced, for example in conjunction with S, or in the alternative to S. Likewise, tellurium may also be introduced. FIG. 6A and 6B further illustrate interconnect structure portion 301 after the formation of upper-level interconnect layers 670, which may be fabricated after chalcogen doping and according to any techniques known to be suitable for integrated circuits. In FIG. 6B, upper-level interconnect layers 670 are depicted in dashed line to emphasize that upper-level interconnect layers 670 include at least one dielectric layer over the metallized trenches 341 and 342, but may also include any number of additional levels of interconnect metallization. In some embodiments, upper-level interconnect layers 670 include a dielectric material suitable as an interconnect diffusion barrier, such as a SiNₓ or SiOₓN_{y}, in direct contact with etch stop material layer 335.

As also shown in FIG. 6A and 6B, following the practice of operation 230 (FIG. 2) interconnect structure portion 301 includes a metal chalcogenide (MCₓ) cap 660 in direct contact with bulk material 550. Although metal chalcogenide cap 660 (FIG. 6B) may be a dichalcogenide (*MC*₂) in some instances, the cap 660 need not be a dichalcogenide because several oxidation states are possible such that x may vary, for example between about 0.2 and 4 in the metal chalcogenide compound *MC*ₓ*.* Consistent with metal dichalcogenides, cap 660 may have crystalline microstructure within a 2D plane of its monolayer(s), and low electron surface scattering qualities of the metal chalcogenide cap 660 may be attributable, at least in part, to this crystalline microstructure. One or more analysis techniques, such a transmission electron microscopy (TEM) coupled with XPS, EDX, or Raman spectroscopy may be employed to identify the presence of particular metal(s) and chalcogen(s) within metal chalcogenide cap 660, as well as quantify the crystal structure metal chalcogenide cap 660 (e.g., from Raman peak widths).

Although metal chalcogenide cap 660 is not limited to a single monolayer, in accordance with some exemplary embodiments metal chalcogenide cap 660 has a thickness less than 8 nm. Cap 660 may be advantageously less than 6 nm (e.g., 2-5 nm) to minimize interconnect resistance attributable to the cap, for example wherever an overlying via (not depicted) intersects the metal chalcogenide cap 660. Metal chalcogenide cap 660 may therefore advantageously have a thickness of two-six monolayers. In the expand view included as an inset of FIG. 6, two *MC₂* monolayers *A* and *B* are illustrated. This depiction is representative of a high-resolution TEM of metal chalcogenide cap 660 following thermal anneal of a *M:C* region comprising sufficient chalcogen dopant concentration to form crystalline monolayers *A* and *B,* each comprising chalcogen atomic layer 660B between two metal atomic layers 660A. Hence, for embodiments where bulk material 550 is Cu doped with S, after a thermal anneal metal atomic layers 660A are substantially Cu and chalcogen atomic layer 660B is substantially S.

The stacked monolayer crystalline structure illustrated in the expanded view extends laterally within an x-y plane substantially parallel to an x-y plane of the interconnect line within interconnect structure portion 301. Each monolayer is continuous over the length of a grain. At a grain boundary, vertical (e.g., z-dimension) alignment of monolayers within two adjacent grains may be offset. For some treatments, the inventors found an average lateral grain length L_{gr} to be at least 1 µm. Hence, grain length L_{gr} is many orders of magnitude (e.g., 1000x) greater than the vertical thickness of each monolayer. Although not bound by theory, the large grain length L_{gr} is currently thought to contribute to a marked reduction in interconnect line resistivity, which the inventors further found to exceed line resistivity reductions associated with graphitic caps having smaller average grain length (e.g., < 10 nm).

As further illustrated in FIG. 6B, the chalcogenation of a top portion of bulk material 550 incurs a negligible interconnect line volume penalty because a top portion of bulk material 550 is converted into metal chalcogenide cap 660 as opposed to metal chalcogenide cap 660 being a discrete cap material deposited upon bulk material 550 as an overlay on the interconnect line. Hence, metal chalcogenide cap 660 occupies volume within the thickness T2 and the capped interconnect line remains substantially co-planar with etch stop material layer 335.

Although FIG. 6A and 6B only illustrate one level of interconnect metallization comprising a line metallization and via metallization, interconnect structure portion 301 may be augmented to have any number of such levels of interconnect metallization according to the demands of a particular IC.

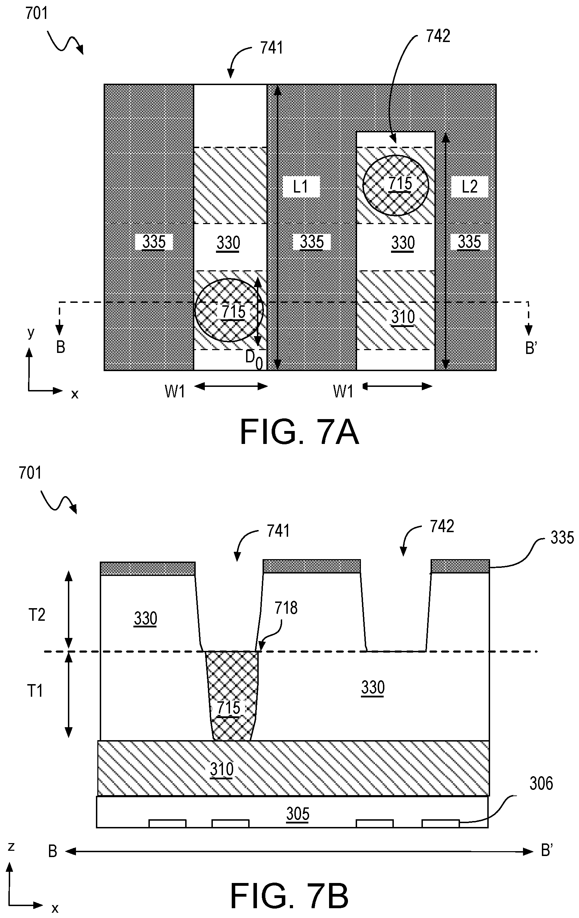

FIG. 7A, 8A, 9A and 10A illustrate a plan view of a portion of an IC interconnect structure portion 701 evolving as methods 201 are practiced, in accordance with some single-damascene embodiments. FIG. 7B, 8B, 9B and 10B further illustrate a cross-sectional view of a portion of an IC interconnect structure portion 701, in accordance with some single-damascene embodiments. Reference numbers are retained where one or more of the attributes introduced above in the context of interconnect structure portion 301 are also applicable to interconnect structure portion 701.

Referring first to FIG. 7A and FIG. 7B, interconnect structure portion 701 includes an electrically conductive via 715 extending through thickness T1 of one or more dielectric materials 330. Conductive via 715 comprises a bulk material that is electrically coupled to underlying metallization feature 310. Conductive via 715 may have been fabricated according to a first single-damascene process, for example. In this example, conductive via 715 has no liner, and may comprise any bulk material suitable for a linerless via, such as, but not limited to, tungsten, molybdenum, titanium, cobalt, or ruthenium. A top surface of conductive via 715 is exposed at a bottom of trench 741 patterned into dielectric materials 330. Separate patterning of conductive via 715 and trench 741 results in a non-zero lateral offset or profile discontinuity 718 at the interface of the sidewall of trench 741 and a sidewall of conductive via 715. Etch stop material layer 335 is again over dielectric materials 330, surrounding trenches 741, 742. As further shown in FIG. 7B, interconnect structure portion 701 is over a portion of an underlying substrate that includes a device layer 305. Within device layer 305 are a plurality of devices 306.

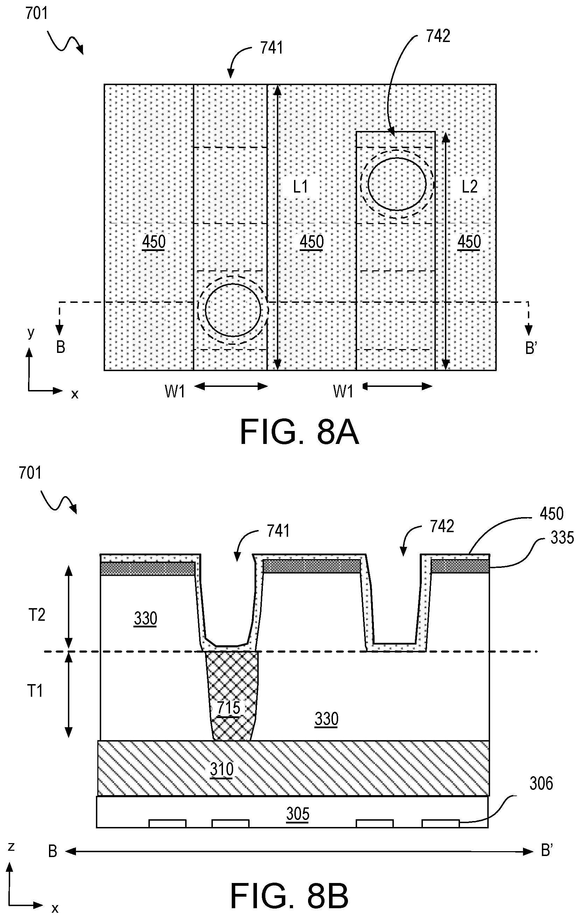

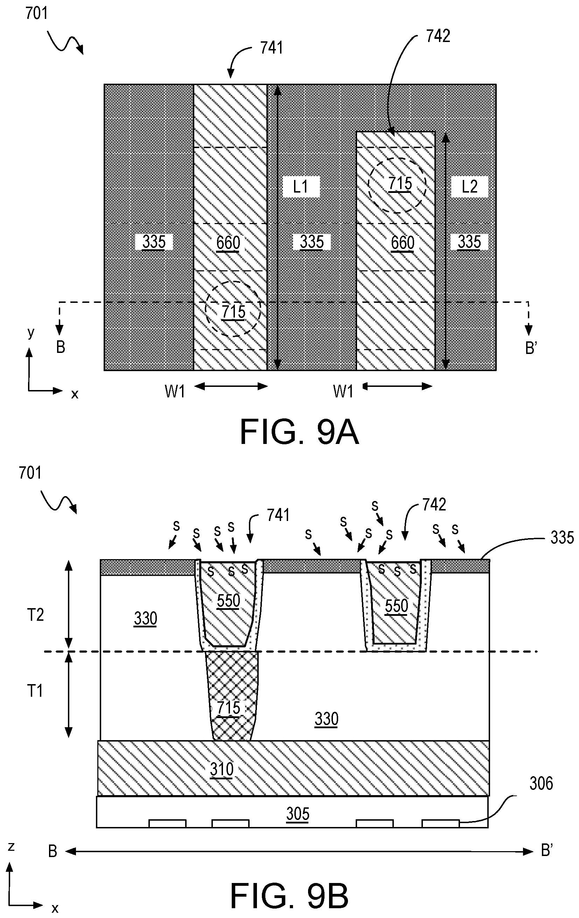

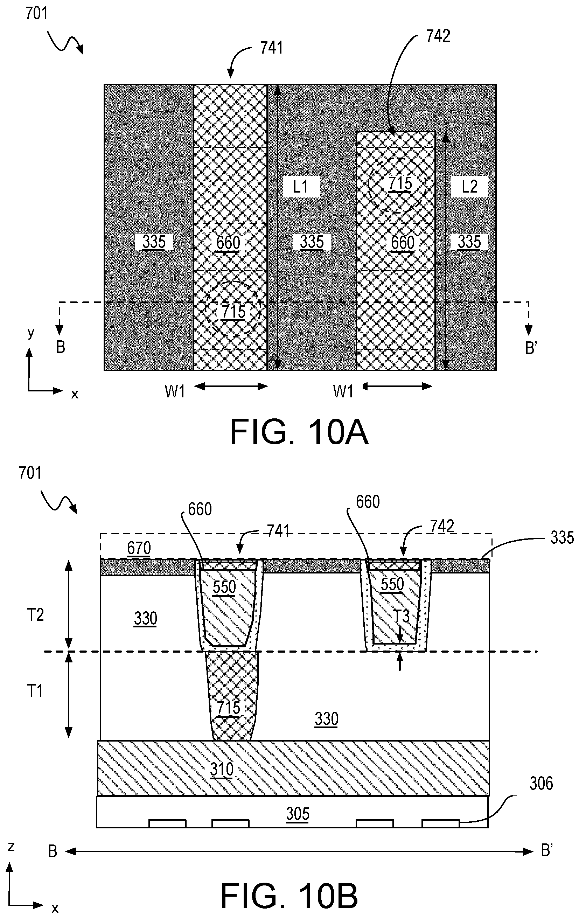

In the single-damascene example further illustrated in FIG. 8A and FIG. 8B, liner material 450 is within trenches 741, 742 and in contact with conductive via 715. Liner material 450 again has a thickness sufficient to function as at least one of an adhesion material layer or a diffusion barrier material layer. As shown in FIG. 9A and FIG. 9B, bulk material 550 substantially backfills trenches 741 and 742. Bulk material 550 is substantially planar with a top surface of the workpiece (e.g., etch stop material layer 335). Interconnect structure portion 701 is therefore a single damascene structure associated with one level of interconnect metallization comprising line metallization and via metallization. Interconnect structure portion 701 may be augmented to have any number of such levels of interconnect metallization as needed for a particular IC. FIG. 9B further illustrates chalcogen (e.g., S) doping of a top portion of bulk material 550, for example substantially as described above. FIG. 10A and 10B illustrate a single-damascene embodiment of interconnect lines including a metal chalcogenide cap 660, which may be formed substantially as described above to have one or more of the physical properties described above.

Interconnect structure portions 301 and 701 may each be incorporated into any IC circuitry as a portion of any IC chip or die that may be singulated from a workpiece following the completion of any conventional processing. With a metal chalcogenide cap in accordance with embodiments herein, interconnect line metallization resistance may be reduced. IC circuitry may therefore display a lower RC delay and higher overall performance. An IC may also display lower power consumption and lower temperatures for a given level of performance.

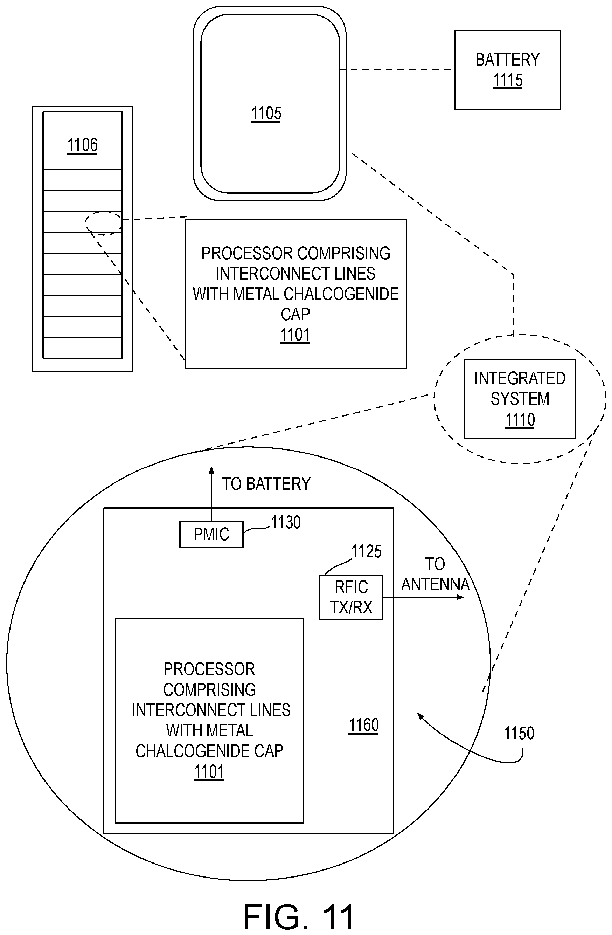

FIG. 11 illustrates a mobile computing platform 1105 and a data server computing platform 1106 employing an IC including interconnect structures with low resistance interconnect lines, for example including a metal chalcogenide cap substantially as described elsewhere herein. The server platform 1106 may be any commercial server, for example including any number of high-performance computing platforms disposed within a rack and networked together for electronic data processing, which in the exemplary embodiment includes a microprocessor 1101 including interconnect structures with low resistance interconnect lines, for example including a metal chalcogenide cap substantially as described elsewhere herein.

The mobile computing platform 1105 may be any portable device configured for each of electronic data display, electronic data processing, wireless electronic data transmission, or the like. For example, the mobile computing platform 1105 may be any of a tablet, a smart phone, laptop computer, etc., and may include a display screen (e.g., a capacitive, inductive, resistive, or optical touchscreen), a chip-level or package-level integrated system 1110, and a battery 1115. At least one IC of chip-level or package-level integrated system 1110 includes interconnect lines with a metal chalcogenide cap, for example substantially as described elsewhere herein.

In the example shown in expanded view 1150, integrated system 1110 includes microprocessor 1101 that includes interconnect lines with a metal chalcogenide cap, for example substantially as described elsewhere herein. Microprocessor 1101 may be further coupled to a host substrate 1160. One or more of a power management integrated circuit (PMIC) 1130 or an RF (wireless) integrated circuit (RFIC) 1125 including a wideband RF (wireless) transmitter and/or receiver (TX/RX) may be further coupled to host substrate 1160.

Functionally, PMIC 1130 may perform battery power regulation, DC-to-DC conversion, etc., and so has an input coupled to battery 1115 and with an output providing a current supply to other functional modules (e.g., microprocessor 1101). As further illustrated, in the exemplary embodiment, RFIC 1125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 4G, 5G, and beyond.

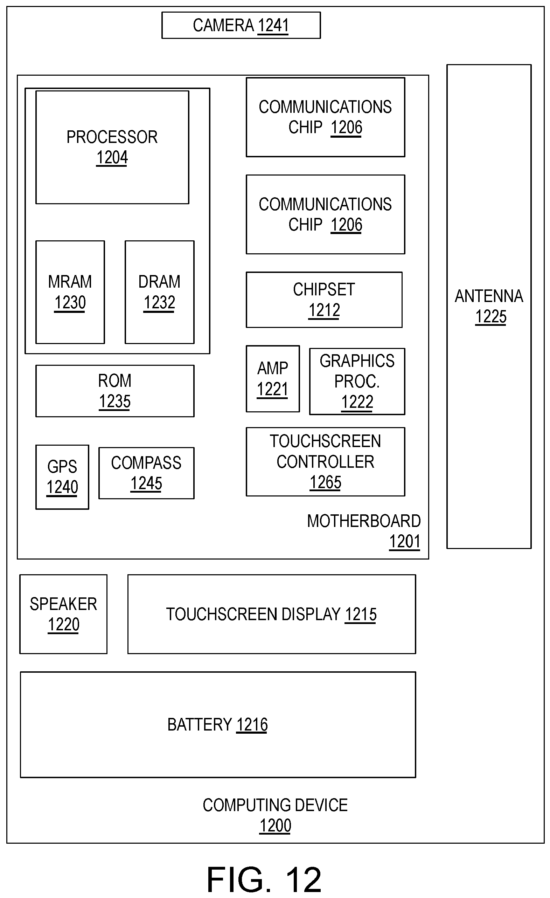

FIG. 12 is a functional block diagram of an electronic computing device 1200, in accordance with an embodiment of the present invention. Computing device 1200 may be found inside platform 1105 or server platform 1106, for example. Device 1200 further includes a motherboard 1201 hosting a number of components, such as, but not limited to, a processor 1204 (e.g., an applications processor). Processor 1204 may be physically and/or electrically coupled to motherboard 1201. In some examples, processor 1204 includes interconnect lines with a metal chalcogenide cap, for example substantially as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1206 may also be physically and/or electrically coupled to the motherboard 1201. In further implementations, communication chips 1206 may be part of processor 1204. Depending on its applications, computing device 1200 may include other components that may or may not be physically and electrically coupled to motherboard 1201. These other components include, but are not limited to, volatile memory (e.g., DRAM 1232), non-volatile memory (e.g., ROM 1235), flash memory (e.g., NAND or NOR), magnetic memory (MRAM 1230), a graphics processor 1222, a digital signal processor, a crypto processor, a chipset 1212, an antenna 1225, touchscreen display 1215, touchscreen controller 1265, battery 1216, audio codec, video codec, power amplifier 1221, global positioning system (GPS) device 1240, compass 1245, accelerometer, gyroscope, speaker 1220, camera 1241, and mass storage device (such as hard disk drive, solid-state drive (SSD), compact disk (CD), digital versatile disk (DVD), and so forth), or the like. In some exemplary embodiments, at least one of the functional blocks noted above include interconnect structures with low via resistance, for example as described elsewhere herein.

Communication chips 1206 may enable wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1206 may implement any of a number of wireless standards or protocols, including but not limited to those described elsewhere herein. As discussed, computing device 1200 may include a plurality of communication chips 1206. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

## Claims

1. An integrated circuit, IC, interconnect structure, comprising:
a via metallization (715) within a dielectric material (330); and
a line metallization over, and coupled to, the via metallization (715), wherein the line metallization comprises:
a bulk material (550) comprising a metal;
a liner material (450) between a bottom of the bulk material and the dielectric material (330); and
a cap material over the bulk material, wherein the cap material (660) comprises the metal and a chalcogen,
**characterized in that**
the cap material (660) has a different crystallinity than the bulk material,
the cap material (660) comprises a first atomic layer (660A) of predominantly the metal in contact with a second atomic layer (660B) of predominantly the chalcogen,
the first monolayer is continuous over a grain length L_{gr} and wherein the grain length L_{gr} is at least 1 µm.

2. The IC interconnect structure of claim 1, wherein the chalcogen comprises S or Se.

3. The IC interconnect structure of claim 2, wherein the metal is Cu.

4. The IC interconnect structure of claim 1, wherein the cap material (660) has a thickness less than 6 nm.

5. The IC interconnect structure of any one of claims 1 to 4, wherein the cap material (660) comprises the first atomic layer (660A) of predominantly the metal between two of the second atomic layers (660B) of predominantly the chalcogen.

6. The IC interconnect structure of any one of claims 1 to 4, wherein the line metallization (450) extends a lateral length within a plane of the IC interconnect structure and the first and second monolayers (660A, 660B) are substantially parallel to the plane.

7. The IC interconnect structure of any one of claims 1-6, further comprising a diffusion barrier over the cap, wherein the diffusion barrier comprises a second dielectric material.

8. The IC interconnect structure of claim 7, wherein the second dielectric material comprises nitrogen and silicon.

9. A computer platform comprising:
a power supply; and
an integrated circuit, IC, coupled to the power supply, wherein the IC comprises:
a device layer comprising a plurality of transistors comprising one or more semiconductor materials; and
a plurality of interconnect levels, the interconnect levels further comprising the IC interconnect structure of claim 1.

10. A method (201) of fabricating an integrated circuit, IC, interconnect structure, the method comprising:
forming (205) a trench in a dielectric material;
depositing (210) a liner material on a surface of the dielectric material;
depositing (220) a bulk material within the trench;
planarizing (220) the bulk material with a surface of the dielectric material; and
reacting a top portion of bulk material with a chalcogen, wherein reacting a top portion of the bulk material with the chalcogen further comprises:
doping (230) at least the top portion of the bulk material with the chalcogen; and
**characterized in**
converting (260) the top portion of the bulk material into a metal chalcogenide having different crystallinity than the bulk material by heating the IC interconnect structure,
wherein the metal chalcogenide comprises a first atomic layer (660A) of
predominantly a metal in contact with a second atomic layer (660B) of predominantly the chalcogen,
wherein the metal chalcogenide is continuous over a grain length L_{gr}, and wherein the grain length L_{gr} is at least 1 µm.

11. The method of claim 10, wherein the chalcogen comprises S, and doping the bulk material with the chalcogen comprises exposing a top surface of the bulk material to a source gas comprising H₂S.

## Patentansprüche

1. Integrierte-Schaltung- bzw. IC(Integrated Circuit)-Zwischenverbindungsstruktur, die Folgendes umfasst:
eine Via-Metallisierung (715) innerhalb eines dielektrischen Materials (330); und
eine Leitungsmetallisierung über, und gekoppelt mit, der Via-Metallisierung (715), wobei die Leitungsmetallisierung Folgendes umfasst:
ein Volumenmaterial (550), das ein Metall umfasst;
ein Auskleidungsmaterial (450) zwischen einer Unterseite des Volumenmaterials und dem dielektrischen Material (330); und
ein Kappenmaterial über dem Volumenmaterial, wobei das Kappenmaterial (660) das Metall und ein Chalkogen umfasst,
**dadurch gekennzeichnet, dass** das Kappenmaterial (660) eine andere Kristallinität als das Volumenmaterial aufweist,
das Kappenmaterial (660) eine erste Atomschicht (660A) aus überwiegend dem Metall in Kontakt mit einer zweiten Atomschicht (660B) aus überwiegend dem Chalkogen umfasst,
die erste Monoschicht über eine Kornlänge L_{gr} kontinuierlich ist und wobei die Kornlänge L_{gr} wenigstens 1 µm beträgt.

2. IC-Zwischenverbindungsstruktur nach Anspruch 1, wobei das Chalkogen S oder Se umfasst.

3. IC-Zwischenverbindungsstruktur nach Anspruch 2, wobei das Metall Cu ist.

4. IC-Zwischenverbindungsstruktur nach Anspruch 1, wobei das Kappenmaterial (660) eine Dicke von weniger als 6 nm aufweist.

5. IC-Zwischenverbindungsstruktur nach einem der Ansprüche 1 bis 4, wobei das Kappenmaterial (660) die erste Atomschicht (660A) aus überwiegend dem Metall zwischen zwei der zweiten Atomschichten (660B) aus überwiegend dem Chalkogen umfasst.

6. IC-Zwischenverbindungsstruktur nach einem der Ansprüche 1 bis 4, wobei sich die Leitungsmetallisierung (450) über eine laterale Länge innerhalb einer Ebene der IC-Zwischenverbindungsstruktur erstreckt und die erste und die zweite Monoschicht (660A, 660B) im Wesentlichen parallel zu der Ebene sind.

7. IC-Zwischenverbindungsstruktur nach einem der Ansprüche 1-6, die ferner eine Diffusionsbarriere über der Kappe umfasst, wobei die Diffusionsbarriere ein zweites dielektrisches Material umfasst.

8. IC-Zwischenverbindungsstruktur nach Anspruch 7, wobei das zweite dielektrische Material Stickstoff und Silicium umfasst.

9. Computerplattform, die Folgendes umfasst:
eine Leistungsversorgung; und
eine integrierte Schaltung, IC, die mit der Leistungsversorgung gekoppelt ist, wobei die IC Folgendes umfasst:
eine Vorrichtungsschicht, die mehrere Transistoren umfasst, die ein oder mehrere Halbleitermaterialien umfassen; und
mehrere Zwischenverbindungsebenen, wobei die Zwischenverbindungsebenen ferner die IC-Zwischenverbindungsstruktur nach Anspruch 1 umfassen.

10. Verfahren (201) zum Herstellen einer Integrierte-Schaltung- bzw. IC-Zwischenverbindungsstruktur, wobei das Verfahren Folgendes umfasst:
Bilden (205) eines Grabens in einem dielektrischen Material;
Abscheiden (210) eines Auskleidungsmaterials auf einer Oberfläche des dielektrischen Materials;
Abscheiden (220) eines Volumenmaterials innerhalb des Grabens;
Planarisieren (220) des Volumenmaterials mit einer Oberfläche des dielektrischen Materials; und
Umsetzen eines oberen Teils des Volumenmaterials mit einem Chalkogen, wobei das Umsetzen eines oberen Teils des Volumenmaterials mit dem Chalkogen ferner Folgendes umfasst:
Dotieren (230) wenigstens des oberen Teils des Volumenmaterials mit dem Chalkogen; und **gekennzeichnet durch** Umwandeln (260) des oberen Teils des Volumenmaterials in ein Metallchalkogenid mit einer anderen Kristallinität als das Volumenmaterials durch Erwärmen der IC-Zwischenverbindungsstruktur,
wobei das Metallchalkogenid eine erste Atomschicht (660A) aus überwiegend einem Metall in Kontakt mit einer zweiten Atomschicht (660B) aus überwiegend dem Chalkogen umfasst,
wobei das Metallchalkogenid über eine Kornlänge L_{gr} kontinuierlich ist und wobei die Kornlänge L_{gr} wenigstens 1 µm beträgt.

11. Verfahren nach Anspruch 10, wobei das Chalkogen S umfasst und das Dotieren des Volumenmaterials mit dem Chalkogen umfasst, dass eine obere Oberfläche des Volumenmaterials einem Quellengas ausgesetzt wird, das H₂S umfasst.

## Revendications

1. Structure d'interconnexion de circuit intégré, CI, comprenant :
une métallisation de trou d'interconnexion (715) au sein d'un matériau diélectrique (330) ; et
une métallisation de ligne au-dessus de, et couplée à, la métallisation de trou d'interconnexion (715), dans laquelle la métallisation de ligne comprend :
un matériau massif (550) comprenant un métal ;
un matériau de doublure (450) entre un fond du matériau massif et le matériau diélectrique (330) ; et
un matériau de coiffe au-dessus du matériau massif, dans laquelle le matériau de coiffe (660) comprend le métal et un chalcogène,
**caractérisée en ce que** le matériau de coiffe (660) présente une cristallinité différente de celle du matériau massif,
le matériau de coiffe (660) comprend une première couche atomique (660A) constituée de manière prédominante du métal en contact avec une seconde couche atomique (660B) constituée de manière prédominante du chalcogène,
la première monocouche est continue sur une longueur de grain L_{gr}, et dans laquelle la longueur de grain L_{gr} est d'au moins 1 µm.

2. Structure d'interconnexion de CI selon la revendication 1, dans laquelle le chalcogène comprend du S ou du Se.

3. Structure d'interconnexion de CI selon la revendication 2, dans laquelle le métal est du Cu.

4. Structure d'interconnexion de CI selon la revendication 1, dans laquelle le matériau de coiffe (660) présente une épaisseur inférieure à 6 nm.

5. Structure d'interconnexion de CI selon l'une quelconque des revendications 1 à 4, dans laquelle le matériau de coiffe (660) comprend la première couche atomique (660A) constituée de manière prédominante du métal entre deux des secondes couches atomiques (660B) constituées de manière prédominante du chalcogène.

6. Structure d'interconnexion de CI selon l'une quelconque des revendications 1 à 4, dans laquelle la métallisation de ligne (450) s'étend selon une longueur latérale dans un plan de la structure d'interconnexion de CI et les première et secondes monocouches (660A, 660B) sont sensiblement parallèles au plan.

7. Structure d'interconnexion de CI selon l'une quelconque des revendications 1 à 6, comprenant en outre une barrière de diffusion sur la coiffe, dans laquelle la barrière de diffusion comprend un second matériau diélectrique.

8. Structure d'interconnexion de CI selon la revendication 7, dans laquelle le second matériau diélectrique comprend de l'azote et du silicium.

9. Plate-forme informatique, comprenant :
une alimentation électrique ; et
un circuit intégré, CI, couplé à l'alimentation électrique, dans lequel le CI comprend :
une couche de dispositifs comprenant une pluralité de transistors comprenant un ou plusieurs matériaux semiconducteurs ; et
une pluralité de niveaux d'interconnexion, les niveaux d'interconnexion comprenant en outre la structure d'interconnexion de CI selon la revendication 1.

10. Procédé (201) de fabrication d'une structure d'interconnexion de circuit intégré, CI, le procédé comprenant :
la formation (205) d'une tranchée dans un matériau diélectrique ;
le dépôt (210) d'un matériau de doublure sur une surface du matériau diélectrique ;
le dépôt (220) d'un matériau massif dans la tranchée ;
la planarisation (220) du matériau massif avec une surface du matériau diélectrique ; et
la réaction d'une partie supérieure du matériau massif avec un chalcogène, dans lequel la réaction d'une partie supérieure du matériau massif avec le chalcogène comprend en outre :
le dopage (230) d'au moins la partie supérieure du matériau massif avec le chalcogène ; et **caractérisé par** la conversion (260) de la partie supérieure du matériau massif en un chalcogénure de métal ayant une cristallinité différente de celle du matériau massif en chauffant la structure d'interconnexion de CI,
dans lequel le chalcogénure de métal comprend une première couche atomique (660A) de manière prédominante constituée d'un métal en contact avec une seconde couche atomique (660B) de manière prédominante constituée du chalcogène,
dans lequel le chalcogénure de métal est continu sur une longueur de grain L_{gr}, et dans lequel la longueur de grain L_{gr} est d'au moins 1 µm.

11. Procédé selon la revendication 10, dans lequel le chalcogène comprend du S, et le dopage du matériau massif avec le chalcogène comprend l'exposition d'une surface supérieure du matériau massif à un gaz source comprenant du H₂S.
